# EUROPÄISCHE PATENTSCHRIFT

(11) **EP 4 131 849 B1**
(45) Veröffentlichungstag und Bekanntmachung des Hinweises auf die Patenterteilung: **28.01.2026**
(21) Anmeldenummer: 22182937.7
(22) Anmeldetag: 05.07.2022
(51) Int. Cl.: G05F 1/46, H04L 12/10, H04L 12/40

(54) **VERSCHALTUNGSELEMENT, PSE-BAUTEIL UND VERFAHREN ZUR ÜBERWACHUNG UND SCHUTZ EINES PODL-NETZES**
SWITCHING ELEMENT, PSE COMPONENT AND METHOD FOR MONITORING AND PROTECTING A PODL NETWORK
ÉLÉMENT DE CIRCUIT, COMPOSANT PSE ET PROCÉDÉ DE SURVEILLANCE ET DE PROTECTION D'UN RÉSEAU PODL

(30) Priorität: 02.08.2021 DE 102021119955
(43) Veröffentlichungstag der Anmeldung: 08.02.2023
(73) Patentinhaber: Turck Holding GmbH, 58553 Halver (DE)
(72) Erfinder: vom Stein, Johannes, 42499 Hückeswagen (DE)
(74) Vertreter: DTS Patent- und Rechtsanwälte PartmbB

(56) Entgegenhaltungen:
- DE-A1- 102020 113 822
- DE-B3- 102015 105 702
- US-A1- 2019 312 751

## Beschreibung

Die vorliegende Erfindung betrifft ein Verschaltungselement nach dem Oberbegriff des Anspruchs 1, ein PSE-Bauteil nach dem Oberbegriff des Anspruchs 6 und ein Verfahren zur Überwachung und zum Schutz eines PoOL-Netzes nach dem Oberbegriff des Anspruchs 8.

Im Stand der Technik sind Sicherungsvorrichtungen für Feldbusanwendungen bekannt und dienen funktional zur sicheren Leistungsbegrenzung zum Schutz von Personen.

Die DE 10 2020 113 822 A1 offenbart eine Ausgangssicherung, bei welcher die Ausgangsschaltelemente zur Testung zyklisch nicht abgeschaltet werden müssen, da sie sich in einem dauerhaft aktiven Regelkreis befinden, durch den ihre Funktionsfähigkeit überwacht wird, wobei unter anderem die Gatespannungen gemessen werden. Diese Verschaltung ist nur für Bustechnologien ausgelegt, bei denen die Datenleitung von den Versorgungsleitungen getrennt sind. Bei der PoDL (Power over Data Line) Technologie werden Spannungsversorgung und Daten über dieselben Adern übertragen. Somit sind keine zusätzlichen Adern vorhanden, um eine funktional sichere Abschaltung zu realisieren, bei der der spannungslose Zustand der sichere Zustand ist. Die vorgenannte Lösung nach der DE 10 2020 113 822 A1 ist somit nicht geeignet für Übermittlungstechnologien, wie Power over Data line (PoOL), Single Pair Ethernet (SPE) etc., bei der die Daten über Versorgungsleitungen übermittelt werden.

Aus der US 7,702,302 B1 ist eine Verschaltung eines SPE bekannt, die in dem Hin- und Rückpfad der Versorgung jeweils einen Feldeffekttransistor (FET) und einen Messwiderstand zur Strommessung aufweist, um hierdurch eine redundante Strommessung zu ermöglichen. Nachteil dieser Verschaltung ist, dass ein zyklischer Test der FETs im eingeschalteten Zustand nicht stattfinden kann und deshalb kein hohes Sicherheitslevel erreicht wird. Weiterhin sind die Messwiderstände im Leistungspfad geschaltet, woraus Leistungsverluste resultieren. Schließlich offenbart die US 2019/0312751 A1 eine Verschaltung eines SPE, die ebenfalls in Hin- und Rückpfad der Versorgung einen FET aufweist. Weiterhin wird ein Sicherheitsalgorithmus vorgeschlagen, bei dem die FETs nacheinander abgeschaltet werden. Der Nachteil dieser Lösung ist, dass während des Sicherheitsalgorithmus keine Kommunikation stattfinden kann und die FETs somit nicht dauerhaft überprüft werden können.

Aus der DE 10 2015 105 702 B3 ist ein Bussystem mit einem Einspeisemodul und einem Verbrauchermodul bekannt. Die US 2019/312751 A1 beschreibt ein Verfahren zum Detektieren von Störungen bei einer Leistungsübertragung via Power over Ethernet.

Es ist die Aufgabe der vorliegenden Erfindung eine verbesserte Verschaltung auch für datentragende Versorgungsleitungen vorzuschlagen (PoDL), bei der die Leistung sicher begrenzt wird.

Diese Aufgabe wird erfindungsgemäß gelöst durch ein Verschaltungselement nach den Merkmalen des Anspruchs 1, ein PSE-Bauteil nach den Merkmalen des Anspruchs 6 und ein Verfahren nach den Merkmalen des Anspruches 8. Vorteilhafte Ausgestaltungen sind in den jeweiligen, zugehörigen Unteransprüchen angegeben.

Danach wird die Aufgabe gelöst durch ein elektronisches Verschaltungselement eines PSE-Bauteils für einen PoDL Netz- oder Netzabschnitt, insbesondere ein SPE-Netz- oder/Netzabschnitt, umfassend einen Spannungsanschluss und/oder Spannungsquelle, eine erste Leitung zum Verbinden eines Pols des Spannungsanschlusses mit einem ersten Anschluss eines Physical Layers (PHY), eine zweite Leitung zum Verbinden des zweiten Pols des Spannungsanschlusses mit dem zweiten Anschluss des Physical Layers (PHY), mindestens ein Schaltelement in jeder der Leitungen, wobei die Schaltelemente mit mindestens einer einen Mikroprozessor umfassenden Regeleinheit verbunden und hierdurch regelbar sind, und wobei mindestens eine Spannungsmesseinheit vorgesehen ist, mittels welcher der Spannungsabfall als Messwert über jedem Schaltelement erfassbar und dem Mikroprozessor zuleitbar ist.

Die Verschaltung sieht verkürzt gesprochen vor, dass Strom und Spannung (wenigstens) redundant gemessen, verrechnet und verglichen werden, um die Leistung zu ermitteln. Die Strommessung findet dabei (zumindest auch) durch die Messung der Gatespannungen mindestens zweier FETs (Feldeffekttransistors) statt.

Mit diesem Verschaltungselement wird eine funktional sichere Leistungsbegrenzung nach der IEC 61508 erreicht. Weiterhin kann zusätzlich eine Eigensicherheit nach der IEEE 802.3cg:2019 erreicht werden. Hierbei besteht eine verbesserte Ausführungsführungsform des Verschaltungselements darin, dass die beiden Schaltelemente im leitenden Zustand eine Spannung als Stellgröße aufweisen, die in Relation zum durchleitenden Strom steht, welche datenleitend mit der Regeleinheit verbunden sind.

Vorteilhafterweise ist hierbei mindestens ein Schaltelement ein Feldeffekttransistor (FET), insbesondere ein normally closed (nc) Feldeffekttransistor. Alternativ können die Schaltelemente auch als MOSFET oder IGBT ausgebildet sein. Es ist insbesondere vorteilhaft, um die Spannungen und Ströme zu vergleichen, wenn die Schaltelemente bau- und funktionsgleich sind, also identisch oder im Wesentlichen identisch ausgebildet sind.

Von der Erfindung ist auch ein (Powering Sourcing Equipment) PSE-Bauteil für ein PoDL Netz- und/oder einen PoDL-Netzabschnitt umfasst, insbesondere ein SPE-Netz- und/oder/Netzabschnitt, das die folgenden Komponenten umfasst
- ein mikroelektronisches Bauteil mit einem Physical Layer (PHY), welches über eine Leitung, insbesondere eine SPE-Verbindung (TPE) mit einem Powered Device (PD) verbindbar ist,
- eine Sicherheitsschaltung, welche eingangs eine Spannungsquelle umfasst und/oder hiermit verbindbar ist, wobei die Sicherheitsschaltung dem mikroelektronischen Bauteil vorgelagert ist, wobei die Sicherheitsschaltung als Verschaltungselement nach einem der vorherigen Ansprüche ausgebildet ist. Hierbei meint "vorgelagert", dass zwischen dem Stromzufluss einer Spannungsquelle und dem einen PHY umfassenden mikroelektronischen Bauteil sowie dem Powered Device (PD) die Sicherheitsschaltung als Überwachungs- und Schutzeinrichtung vorgesehen ist.

Das PSE-Bauteil kann dahingehend weiter verbessert werden, indem der Physical Layer (PHY) zwei Anschlüsse aufweist, wobei jedem der Anschlüsse unmittelbar vorgelagert eine Verschaltung passiver Bauelemente, insbesondere mindestens eines Widerstandes und mindestens eine Kapazität.

Das Verschaltungselement beinhaltet einen PHY, ein PSE-Bauteil und eine Kopplung mit passiven Bauelementen. Die Kopplung Richtung PHY muss sicherheitsgerichtet ausgelegt sein. Der Ausfall eines Bauteils darf nicht dazu führen, dass über diesen Weg Leistung eingekoppelt wird. Das kann so ausgeführt werden, wie es in der der IEEE 802.3cg:2019 zum Erreichen von Eigensicherheit vorgeschlagen wird. Dort werden die kritischen Bauteile doppelt, je nach Funktion hintereinander oder nebeneinander geschaltet.

Weiterhin ist von der Erfindung ein Verfahren zur Überwachung und Schutz eines PoDL-Netzes und/oder Netzabschnitts umfasst, wobei in zwei mit einer Spannungsquelle verbunden Leitungen jeweils mindestens ein Schaltelement vorgesehen ist und der Spannungsabfall über jedem Schaltelement gemessen wird, wobei in Abhängigkeit von den IST-Spannungsmesswerten (Regelgröße) die Schaltelemente mittels einer Spannung (Stellgröße) angesteuert werden, die in Relation zum Stromfluss (Störgröße) steht.

Bei einer verbesserten Verfahrensvariante wird in beiden Leitungen der Stromfluss technisch unabhängig gemessen und die Messwerte und/oder hieraus abgeleitete Daten gemeinsam in einer Prozessoreinheit ausgewertet, indem der Stromfluss in jedem Schaltelement anhand der Ansteuerspannung ermittelt und der Stromfluss der beiden Schaltelemente zur Überwachung verglichen wird.

Vorteilhafterweise wird der Stromfluss in jedem Schaltelement anhand der Ansteuerspannung (U_GS, Gatespannung) der Stromfluss Störgröße, I-S)gemessen, das bedeutet rechnerisch aus den Ansteuerspannungen (U_GS, Gatespannung) ermittelt. Diese Ermittlung erfolgt in beiden Schaltelementen parallel und unabhängig. Mittels der so generierten und verglichenen Stromflüsse (Durchflussströme) wird das Netz oder Netzabschnitte überwacht und basierend hierauf gegebenenfalls erforderliche Prozesssteuerung, Warnmeldungen und/oder Abschaltungen veranlasst.

Ein Verfahrensverbesserung besteht darin, dass der IST-Spannungsmesswert auf mindestens einem der Leitungsabschnitten der mit der Spannungsquelle verbunden Leitungen vor oder nach den Schaltelementen abgegriffen wird, nämlich
- zwischen Spannungsquelle und den Schaltelementen (vor) und/oder
- von der Spannungsquelle aus gesehen nach den Schaltelementen abgegriffen wird. Im ersten Fall ("vor" den Schaltelementen) wird die IST-Spannung auf der Source-Seite des Schaltelements in der Pluspol-Leitung und auf der Drain-Seite des Schaltelements in der Minuspol-Leitung abgegriffen. Im zweiten Fall ("nach" den Schaltelementen) wird die IST-Spannung auf der Drain-Seite des Schaltelements in der Pluspol-Leitung und auf der Source-Seite des Schaltelements in der Minuspol-Leitung abgegriffen. Die beiden IST-Spannungen können parallel, sequenziell und/oder getaktet zur Überwachung gemessen werden.

Bei dem Verfahren ist also vorgesehen, dass sich die Schaltelemente, wie beispielsweise die FET, in einem Regelkreis befinden. Parallel wird der Durchflussstrom anhand der Ansteuerspannung (U_GS, Gatespannung) ermittelt und der Durchflussstrom der beiden Schaltelemente verglichen und hierüber überwacht. Wird eine Ungleichheit des Durchflussstroms ermittelt, werden beide Schaltelemente abgeschaltet, weil die Ungleichheit auf einen Fehler verweist, der entweder im Schaltelement selbst oder in einem eingekoppelten Fremdpotential besteht.

Hierbei wird der redundant gemessene Durchflussstrom ausgewertet und mit einer Vorgabe, wie einer FET-Kennkurve, verglichen. Der Strom wird dabei im Normalfall nicht aktiv begrenzt, sondern überwacht und bei Überschreitung abgeschaltet. Die PHY Sendeleistung wird nicht gesondert gemessen, überwacht oder begrenzt, sondern die eigentliche Versorgung und/oder die Spannungsquelle selbst wird komplett abgeschaltet. Vorteilhafterweise verbleibt eine Sendeleistung des PHY als autonomes Signal auch nach einer Abschaltung, dessen Sendeleistung kleiner 0,5 Watt ist.

Zur Überwachung der Funktionsweise und Funktionsfähigkeit der Schaltelemente selbst, ist bei einer weiter verbesserten Verfahrensvariante vorgesehen, dass eine SOLL-Kennkurve für jedes Schaltelement gespeichert wird und der Widerstandswert und/oder die Gatespannung (U_GS) der beiden Schaltelemente in definierten Grenzen verändert und der IST-Wert mit der SOLL-Kennlinie und/oder Korridor der SOLL-Kennlinie des jeweiligen Schaltelements verglichen wird. Die Änderung des Widerstandswertes und/oder der jeweiligen Gatespannung (U_GS) kann einzeln oder synchron erfolgen.

Eine weitere, verbesserte Verfahrensvariante sieht vor, dass nach einer Abschaltung wegen einer Erfassung einer ungleichen Stromstärke und/oder eines ungleichen Stromflusses, ein Benutzereingriff vor einer erneuten Einschaltung erfolgt, insbesondere nach einer Fehleranalyse und/oder Fehlerbehebung durch einen Benutzer oder einer Vorgabe der Steuerung erfolgt, indem eine Ausgangsbegrenzung oder eine Leistungsbegrenzung vorgegeben wurde, erfolgt eine erneute Einschaltung und/oder der Normalbetrieb aufgrund interner Vorgaben der Steuerung.

Vorteilhafterweise wird bei dem Verfahren ein PSE-Bauteil eingesetzt, das nach einem der vorstehenden Ausführungsformen ausgebildet ist und entsprechend betrieben wird. Das hierin beschriebene Verfahren in den diversen Ausführungsformen kann insbesondere für ein Versorgungs- und Datennetzwerk verwendet werden, bei welchem die Datenübermittlung und die Stromleitung gemeinsam über ein zweiadriges Kabel erfolgt, insbesondere ein Single Pair Ethernet (SPE) und/oder Twisted Pair Ethernet (TPE).

Dabei kann die Begrenzung des Stroms darin bestehen, dass eine vollständige Stromabschaltung auf 0 A erfolgt oder auf einen definierten Wert > 0 erfolgt, insbesondere auf einen Wert bis 100 mA. Der Vorteil einer nicht vollständigen Abschaltung besteht darin, dass mit dem geringen Stromfluss auch eine Datenübertragung fortgeführt werden kann, um beispielsweise Zustandsdaten zu übermitteln oder Steuerbefehle weiterleiten zu können.

Der besondere Vorteil besteht darin, dass dieselben FETs als Ausgansschaltelemente zur Strommessung genutzt werden, die auch zur Abschaltung genutzt werden, so dass keine zusätzlichen Bauteile im Leistungspfad eingebaut werden müssen. Somit wird auch mittels dieser Verschaltung eine sichere Leistungsbegrenzung und Abschaltung eines elektronischen Bauteils oder Gerätes ermöglicht, welches selbst keine Sicherheitsfunktion umfasst, wie beispielsweise ein Frequenzumrichter. Auf eine aufwändige funktional sichere Bus-Kommunikation kann mit der erfindungsgemäßen Verschaltung verzichtet werden, da die Leistungsbegrenzung und bedarfsweise Abschaltung übergeordnet stattfind.

Weitere Einzelheiten und Vorteile der Erfindung sollen nun anhand von in Zeichnungen dargestellten Ausführungsbeispielen näher erläutert.

Es zeigt:
- Fig. 1: ein Schaltbild einer ersten Ausführungsform,
- Fig. 2: ein Schaltbild einer weiteren Ausführungsform und
- Fig. 3: eine Skizze der Schaltung sowie Graphen der Kennlinien der FET.

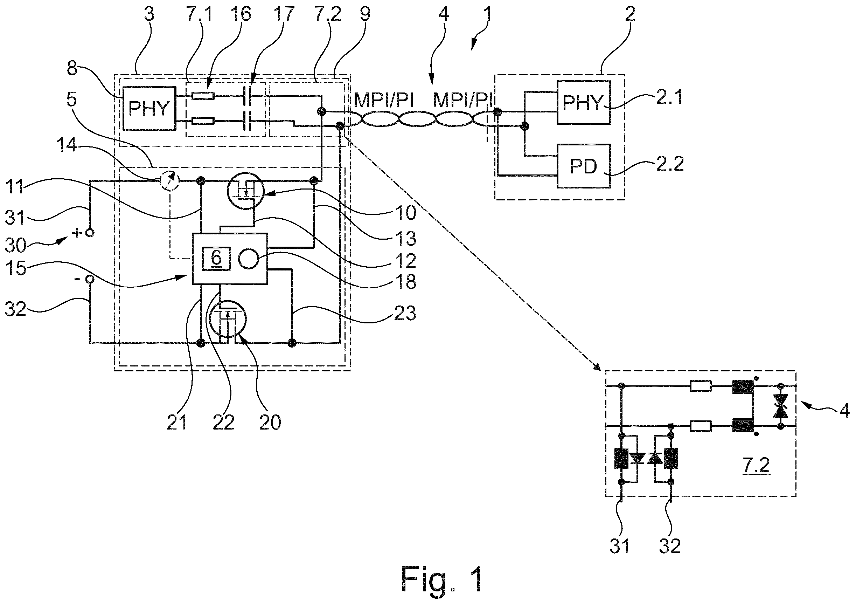

Der in Figur 1 gezeigte PoDL Netz- oder Netzabschnitt 1 ist wie regulär in der IEEE 802.3cg:2019 vorgesehen aufgebaut. Er umfasst einen Physical Layer 8 (PHY) zur Kommunikation der Daten auf beiden Seiten der SPE-Stecke 4, nämlich auf der Seite des PSE 3 (Power Sourcing Equipment) und auf der anderen Seite der SPE-Strecke, dem PD 2 (Powered Device).

Die erfindungsgemäße Ausführungsform betrifft die Seite des PSE 3, so dass das PD 2 nicht näher ausgeführt wird und die dem Fachmann geläufigen (mikro-)elektronischen Bauteile und Komponenten umfasst.

Das PSE 3 umfasst im Wesentlichen eine Schutzbeschaltung 9 aus dem PHY 8 und den passiven Bauelementen 7.1, 7.2 und ein Verschaltungselement 5. Die Schutzbeschaltung 9 umfasst die passiven Bauelemente 7.1 und 7.2 zur Kopplung von PHY und PSE. Solche passiven Bauteile 7.1, 7.2 sind für die Kopplung nötig. Hierbei muss das passive Bauelemente 7.1 sicherheitsgerichtet ausgelegt werden. Hierdurch wird im Falle eines Einfachfehlers die Schutzfunktion aufrecht erhalten, wodurch ein sicherheitsrelevanter Fehler sehr unwahrscheinlich ist. Hierbei gilt die Sendeleistung des PHY 8 gilt als unterstes Leistungslevel. Idealerweise entspricht die Erkennung des PD 2 über eine Detektionsspannung und die Übermittlung der Leistungsklassen über SCCP (Serial Communication Classification Protocoll) den üblichen Normen. Vorliegend ist in der Schutzbeschaltung 9 ein passives Bauelement 7.1 vorgesehen, das einen in Reihe geschalteten Widerstand 16 und einen Kondensator 17 umfasst. Der Aufbau des zweiten, passiven Bauelements 7.2 ist in der unteren Detaildarstellung vergrößert und mit den Einzelkomponenten dargestellt.

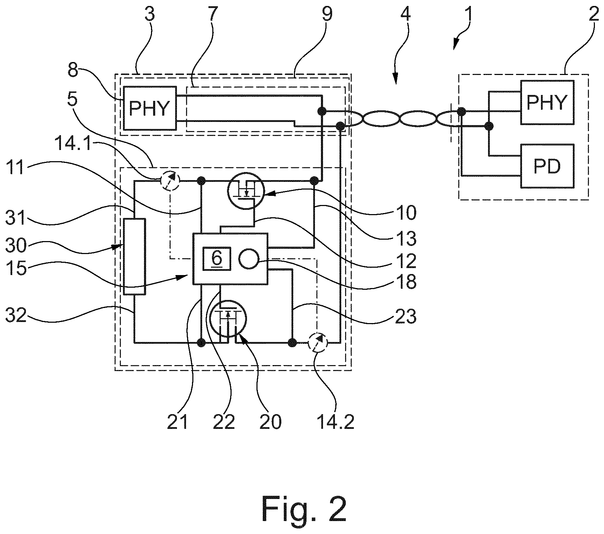

Das Verschaltungselement 5 umfasst einen Spannungsanschluss 30 (positiver Pos) mit einer ersten Leitung 31, welche zum ersten Anschluss 8.1 des eines Physical Layers (PHY) 8 führt. Die zweite Leitung 32 verbindet den anderen Spannungsanschlusses 30 (negativer Pol) mit dem zweiten Anschluss 8.2 des PHY 8 der PSE 3. Beide Leitungen 31, 32 umfassen jeweils ein als FET ausgebildetes Schaltelement 10, 20. Der Spannungsanschluss 30 kann zu einer externen Quelle führen, wie in Figur 1 angedeutet oder in eine integrierte Quelle, wie eine Batterie ausgebildet sein, wie in Figur 2 dargestellt. Eine zentrale Regeleinheit 15 greift über das Leitungspaare 11, 13 in der ersten Leitung 31 und über das Leitungspaar 21, 23 in der zweiten Leitung 32 die Spannung (U_DS) über dem jeweiligen Schaltelement 10, 20 (FET) ab. Weiterhin wird jedes Schaltelement 10, 20 über eine jeweils zugehörige Steuerleitung 12, 22, die mit der Regeleinheit 15 verbunden ist, gesteuert und geregelt. Die Regeleinheit 15, welche beispielsweise als Grundträger eine Platine aufweist, umfasst ebenfalls einen Mikroprozessor 6 für mindestens einen Teil der Datenverarbeitung sowie eine Spannungsmesser 18. Sonstige, übliche weitere (mikro-)elektronische Elemente der Regeleinheit 15 sind nicht dargestellt. In dem gezeigten Ausführungsbeispiel erfolgt die die Regelung elektronisch über Operationsverstärker, kann aber auch über den Mikroprozessor erfolgen. Vorliegend dient der Mikroprozessor Steuerungs- und Überwachungszwecken.

Die erfindungsgemäße funktional sichere Abschaltung betrifft nur das PSE 3. Somit kann bei Abschaltung die Leistung nur begrenzt werden, auf die maximale Sendeleistung des PHY 8. Ethernet kann optional als schwarzer Kanal für ein sicheres Protokoll genutzt werden. Somit ist es möglich, ein sicheres Protokoll (z.B. PROFIsafe oder CIPP Safety) zu betreiben. Es kann sowohl ein sicheres Protokoll als auch ein Standardprotokoll betrieben werden. Der Vorteil der Erfindung besteht allerdings darin, dass auch ohne ein sicheres Protokoll die übergeordnete sichere Abschaltung möglich ist.

Die Bemessungsspannungen und Ströme für das PSE 3 nach IEEE 802.3cg:2019 sind in der nachstehenden Tabelle aufgeführt und können alle vorgesehen werden.

**Tabelle**

| **Klasse** | **0** | **1** | **2** | **3** | **4** | **5** | **6** | **7** | **8** | **9** |
|---|---|---|---|---|---|---|---|---|---|---|
| Spannung [V] | 5.5-18 | 5.5-18 | 14-18 | 14-18 | 12-36 | 12-36 | 26-36 | 26-36 | 48-60 | 48-60 |
| Stromstärke [A] | 0.1 0 | 0.22 | 0.25 | 0.47 | 0.10 | 0.34 | 0.21 | 0.46 | 0.73 | 1.3 |
| PD Leistung | 0.5 | 1 | 3 | 5 | 1 | 3 | 5 | 10 | 30 | 50 |

In der Figur 1 ist weiterhin ein zusätzliches Amperemeter 14 als optionale Erweiterung dargestellt, der über eine strichpunktierte Datenleitung ebenfalls mit der Regeleinheit 15 verbunden ist. Der hierdurch in der Pluspol-Leitung 31 gemessene Stromfluss kann mit dem aus den Spannungen ermittelten Strömen verglichen und zur Überwachung genutzt werden. Wie in Figur 2 dargestellt, kann diese zusätzliche, separate Strommessung weiter verbesserten werden, wenn in beiden Leitung 31, 32 ein zusätzliches Amperemeter 14.1, 14.2 vorgesehen wird und die so ermittelten Ströme verglichen und zur Überwachung genutzt werden.

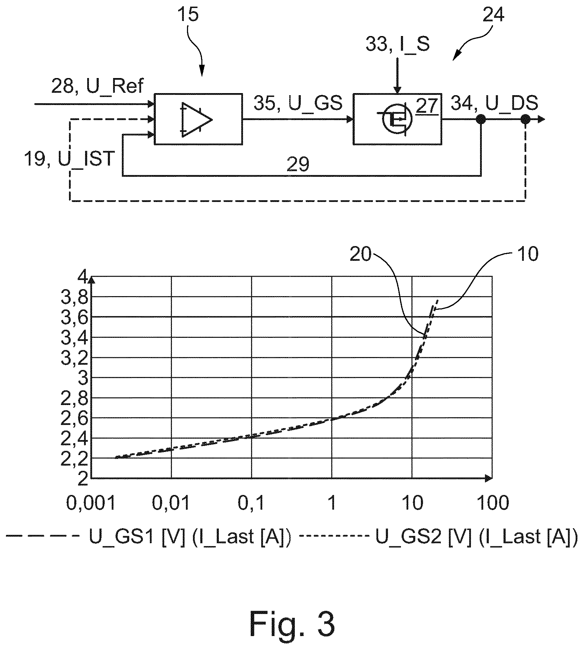

Wie in der Figur 3 ausgeführt, befinden sich die die Schaltelemente (FET) im eingeschalteten Zustand in einem Regelkreis 24, bei dem die Spannung 34 (U_DS) als Regelgröße konstant gehalten wird. Diese Spannung 34 wird über die die Leitungen 11, 13 in der Leitung 31 und über die Leitungen 21, 23 in der Leitung 32 abgegriffen, wie in den Figuren 1 und 2 dargestellt. Die über die Steuerleitungen 12, 22 angelegte (Gate-)Spannung 35 (U_GS) steht dabei in einem typischen Verhältnis zur Störgröße 33 (I_S) des fließenden Stroms. Dieser Zusammenhang kann für jedes Stellelement 10, 12 einer bauteilspezifischen Kennlinie entnommen werden, wie in dem unteren Graphen in der Figur 3 dargestellt wurde.

Weiterhin kann optional, wie mit dem gestrichelten Pfeil angedeutet, die Ausgangsspannung 19 (U_IST) über die Leitungen 13 in der ersten Leitung 31 (plusPol) und der zweiten Leitung 32 (minus-Pol) über die Leitung 23 zurück gelesen ebenfalls (redundant) gemessen werden, was vorstehend als "hinter" den Schaltelementen 10, 20 bezeichnet wurde. Alternativ kann in analoger Weise über das Leitungspaar 11, 21 gemessen werden, was vorstehend als "vor" den Schaltelementen 10, 20 bezeichnet wurde.

Erfolgt lediglich die Abschaltung der Versorgung, wird das PHY 8 auf die Sendeleistung begrenzt. Hierzu ist es nicht erforderlich, die die Leistung oder den Strom exakt zu messen. Die Strommessung dient im Wesentlichen der Überwachung der als FET ausgebildeten Schaltelemente 10, 20. Somit sind bei dieser Variante regulär nur zwei sichere Leistungsstufen vorgesehen.

Alternativ kann eine sicherheitsgerichtete Messung des Stromes und der Spannung erfolgen, woraus die Berechnung der Leistung vorgenommen wird. Diese wird verglichen mit einer Vorgabe, wie z.B. den Leistungsklassen nach IEEE 802.3cg:2019 gemäß der vorstehenden Tabelle. Hierzu muss die Vorgabe grundsätzlich sicher konfiguriert sein. Ein gegebenenfalls vorliegendes Skinny Client Control Protokoll (SCCP) hat eine Kontrollwirkung. Wird die Vorgabe nicht eingehalten, wird eine sichere Abschaltung eingeleitet.

### Bezugszeichenliste

1 PoDL Netz- oder Netzabschnitt (1)
2 Powered Device (PD)
3 PSE-Bauteil
4 SPE
5 Verschaltungselement (5)
6 Mikroprozessor, Prozessoreinheit
7 Bauelement, passives (auch 7.1, 7.2)
8 Physical Layer (PHY)
   8.1 Anschluss, erster
   8.2 Anschluss, zweiter
9 Schutzverschaltung
10 Schaltelement
11 Leitung
12 Steuerleitung
13 Leitung
14 Amperemeter (auch 14.1, 14.2)
15 Regeleinheit
16 Widerstand
17 Kapazität
18 Spannungsmesser
19 Ausgangsspannung (U_IST)
20 Schaltelement
21 Leitung
22 Steuerleitung
23 Leitung
24 Regelkreis
   27 Regelstrecke
28 Führungsgröße (U_Ref)
29 Rückführung
30 Spannungsanschluss
31 Leitung, erste
32 Leitung, zweite
33 Störgröße (I_S)
34 Regelgröße (U_DS)
35 Stellgröße (U_GS)

## Patentansprüche

1. Elektronisches Verschaltungselement (5) für ein PSE-Bauteil, (3), "Powering Sourcing Equipment"-Bauteil, für einen PoDL Netz- oder Netzabschnitt (1), "Power over Data Line", umfassend
- einen Spannungsanschluss (30) und/oder Spannungsquelle,
- eine erste Leitung (31) zum Verbinden eines Pols des Spannungsanschlusses (30) mit einem ersten Anschluss (8.1) eines PHY (8),
- eine zweite Leitung (32) zum Verbinden des zweiten Pols des Spannungsanschlusses (30) mit einem zweiten Anschluss (8.2) des PHY (8),
- mindestens ein Schaltelement (10, 20) in jeder der Leitungen (31, 32),
**dadurch gekennzeichnet, dass**
die Schaltelemente (10, 20) mit mindestens einer einen Mikroprozessor (6) umfassende Regeleinheit (15) verbunden und hierdurch mittels einer Spannung, die in Relation zum Stromfluss steht, regelbar sind, und
wobei mindestens eine Spannungsmesseinheit (18) vorgesehen ist, mittels welcher ein Spannungsabfall als Messwert über jedem Schaltelement (10, 20) als IST-Spannungsmesswerte erfassbar und dem Mikroprozessor (6) zuleitbar ist,
wobei die Regeleinheit (15) dazu eingerichtet ist, die Schaltelemente (10, 20) in Abhängigkeit von den IST-Spannungsmesswerten anzusteuern, dass der Spannungsabfall (U_DS) über jedem Schaltelement (10, 20) als Regelgröße konstant gehalten wird.

2. Verschaltungselement (5) nach Anspruch 1, **dadurch gekennzeichnet, dass** zum Messen eines Stromflusses in zumindest einer Leitung (31, 32) ein Amperemeter (14.1, 14.2) vorgesehen ist, das datenleitend mit der Regeleinheit (15) verbunden ist.

3. Verschaltungselement (5) nach einem der Ansprüche 1 oder 2, **dadurch gekennzeichnet, dass** mindestens ein Schaltelement (10, 20) ein Feldeffekttransistor, FET, ist, insbesondere ein normally closed, nc, Feldeffekttransistor.

4. Verschaltungselement (5) nach Anspruch 3, **dadurch gekennzeichnet, dass** das mindestens ein Schaltelement (10, 20) ein MOSFET oder ein IGBT ist.

5. Verschaltungselement (5) nach einem der vorherigen Ansprüche, **dadurch gekennzeichnet, dass** die Schaltelemente (10, 20) bau- und funktionsgleich sind.

6. PSE-Bauteil (3) für ein PoDL Netz- und/oder einen PoDL-Netzabschnitt (1), umfassend
- ein mikroelektronisches Bauteil (9) mit einem PHY (8), welches über eine Leitung mit einem Powered Device, PD, (2) verbindbar ist,
- eine Sicherheitsschaltung, welche eine Spannungsquelle umfasst und/oder hiermit verbindbar ist, wobei die Sicherheitsschaltung dem mikroelektronischen Bauteil (9) vorgelagert ist,
**dadurch gekennzeichnet, dass**
die Sicherheitsschaltung als Verschaltungselement (5) nach einem der vorherigen Ansprüche ausgebildet ist.

7. PSE-Bauteil (3) nach Anspruch 6, **dadurch gekennzeichnet, dass** der PHY (8) zwei Anschlüsse (8.1, 8.2) aufweist, wobei jedem der Anschlüsse (8.1, 8.2) eine Verschaltung passiver Bauelemente unmittelbar vorgelagert, insbesondere eine Verschaltung mindestens eines Widerstandes (16) und mindestens einer Kapazität (17).

8. Verfahren zur Überwachung und Schutz eines PoDL-Netzes und/oder Netzabschnitts, wobei in zwei mit einer Spannungsquelle verbundenen Leitungen (31, 32) jeweils mindestens ein Schaltelement (10, 20) vorgesehen ist und der Spannungsabfall (U_DS) über jedem Schaltelement (10, 20) als IST-Spannungsmesswerte gemessen wird, **dadurch gekennzeichnet, dass** in Abhängigkeit von den IST-Spannungsmesswerten die Schaltelemente (10, 20) mittels einer Ansteuerspannung angesteuert werden, die in Relation zum Stromfluss steht, wobei die Schaltelemente (10, 20) in Abhängigkeit von den IST-Spannungsmesswerten so angesteuert werden, dass der Spannungsabfall (U_DS) über jedem Schaltelement (10, 20) als Regelgröße konstant gehalten wird.

9. Verfahren nach Anspruch 8, **dadurch gekennzeichnet, dass** in beiden Leitungen (31, 32) der Stromfluss technisch unabhängig gemessen wird und die Messwerte und/oder hieraus abgeleitete Daten gemeinsam in einer Prozessoreinheit (6) ausgewertet werden.

10. Verfahren nach Anspruch 9, **dadurch gekennzeichnet, dass** der Stromfluss in jedem Schaltelement (10, 20) anhand der Ansteuerspannungen der Stromfluss (33)der beiden Schaltelemente (10, 20) ermittelt und zur Überwachung verglichen werden.

11. Verfahren nach einem der Ansprüche 8 bis 10, **dadurch gekennzeichnet, dass** der IST-Spannungsmesswert auf den Leitungsabschnitten der Leitungen (31, 32)
a) zwischen Spannungsquelle und Schaltelement (10,20) und/oder
b) von der Spannungsquelle aus gesehen nach den Schaltelementen (10, 20) erfasst wird.

12. Verfahren nach einem der Ansprüche 8 bis 11, **dadurch gekennzeichnet, dass** nach einer Abschaltung wegen
a) einer Erfassung einer ungleichen Stromstärke ein Benutzereingriff vor einer erneuten Einschaltung erfolgt, insbesondere nach einer Fehleranalyse und/oder Fehlerbehebung durch einen Benutzer, oder
b) einer Vorgabe der Steuerung, indem eine Ausgangsbegrenzung oder eine Leistungsbegrenzung vorgegeben wurde, eine erneute Einschaltung und/oder der Normalbetrieb aufgrund interner Vorgaben der Steuerung erfolgt.

13. Verfahren nach einem der Ansprüche 8 bis 12, **dadurch gekennzeichnet, dass** ein PSE-Bauteil (3) nach einem der Ansprüche 6 oder 7 verwendet und betrieben wird.

14. Verfahren nach einem der Ansprüche 8 bis 13, **dadurch gekennzeichnet, dass** das Verfahren für ein Versorgungs- und Datennetzwerk verwendet wird, bei welchem die Datenübermittlung und die Stromleitung gemeinsam über ein zweiadriges Kabel erfolgt, insbesondere ein Single Pair Ethernet, SPE, (4) und/oder Twisted Pair Ethernet, TPE.

15. Verfahren nach einem der Ansprüche 8 bis 14, **dadurch gekennzeichnet, dass** eine Begrenzung des Stroms darin besteht, dass eine Stromabschaltung
- auf 0 A erfolgt oder
- auf einen definierten Wert > 0 erfolgt, insbesondere auf einen Wert bis 100 mA.

16. Verfahren nach einem der Ansprüche 8 bis 15, **dadurch gekennzeichnet, dass** aus den IST-Spannungsmesswerten (U_GS) an den beiden Schaltelementen (10, 20) ihre Stromstärke (33) errechnet wird und dass diese Stromstärke (33) mit einer in der Prozessoreinheit (6) vorgegebenen SOLL-Stromstärke sowie zusätzlich mit einer unabhängig gemessenen IST-Stromstärke in mindestens einem beiden Leitungswege (30, 31) verglichen wird, wobei in Abhängigkeit von diesem Vergleich eine Abschaltung erfolgt.

## Claims

1. Electronic interconnection element (5) for a PSE component, (3), "Power Sourcing Equipment" component, for a PoDL network or network section (1), "Power over Data Line", comprising
- a voltage terminal (30) and/or voltage source,
- a first line (31) for connecting a pole of the voltage terminal (30) to a first terminal (8.1) of a PHY (8),
- a second line (32) for connecting the second pole of the voltage terminal (30) to a second terminal (8.2) of the PHY (8),
- at least one switching element (10, 20) in each of the lines (31, 32),
**characterized in that**
the switching elements (10, 20) are connected to at least one control unit (15) comprising a microprocessor (6) and can thus be controlled by means of a voltage that is related to the current flow, and wherein at least one voltage measuring unit (18) is provided, by means of which a voltage drop, as measured value, across each switching element (10, 20) can be detected and supplied to the microprocessor (6) as ACTUAL voltage measured values,
wherein the control unit (15) is set up to actuate the switching elements (10, 20) depending on the ACTUAL voltage measured values, so that the voltage drop (U_DS) across each switching element (10, 20) is kept constant as a control variable.

2. Interconnection element (5) according to Claim 1, **characterized in that** an ammeter (14.1, 14.2), which is connected to the control unit (15) for data transmission, is provided to measure a current flow in at least one line (31, 32).

3. Interconnection element (5) according to either one of Claims 1 and 2, **characterized in that** at least one switching element (10, 20) is a field-effect transistor, FET, in particular a normally closed, nc, field-effect transistor.

4. Interconnection element (5) according to Claim 3, **characterized in that** the at least one switching element (10, 20) is a MOSFET or an IGBT.

5. Interconnection element (5) according to any one of the preceding claims, **characterized in that** the switching elements (10, 20) are identical in terms of construction and function.

6. PSE component (3) for a PoDL network and/or a PoDL network section (1), comprising
- a microelectronic component (9) having a PHY (8), which can be connected via a line to a Powered Device, PD, (2),
- a safety circuit which comprises a voltage source and/or which can be connected thereto, wherein the safety circuit is located upstream of the microelectronic component (9),
**characterized in that**
the safety circuit is in the form of an interconnection element (5) according to any one of the preceding claims.

7. PSE component (3) according to Claim 6, **characterized in that** the PHY (8) has two terminals (8.1, 8.2), wherein an interconnection of passive components is located directly upstream of each of the terminals (8.1, 8.2), in particular an interconnection of at least one resistor (16) and at least one capacitance (17).

8. Method for monitoring and protecting a PoDL network and/or network section, wherein at least one switching element (10, 20) is provided in each of two lines (31, 32) that are connected to a voltage source, and the voltage drop (U_DS) across each switching element (10, 20) is measured as ACTUAL voltage measured values, **characterized in that**, depending on the ACTUAL voltage measured values, the switching elements (10, 20) are actuated by means of an actuation voltage that is related to the current flow, wherein the switching elements (10, 20) are actuated depending on the ACTUAL voltage measured values in such a way that the voltage drop (U_DS) across each switching element (10, 20) is kept constant as a control variable.

9. Method according to Claim 8, **characterized in that** the current flow is measured in both lines (31, 32) technically independently and the measured values and/or data derived therefrom are evaluated together in a processor unit (6).

10. Method according to Claim 9, **characterized in that** the current flow in each switching element (10, 20) is determined on the basis of the actuation voltages of the current flow (33) of the two switching elements (10, 20) and compared for monitoring.

11. Method according to any one of Claims 8 to 10, **characterized in that** the ACTUAL voltage measured value on the line sections of the lines (31, 32) is detected
a) between the voltage source and the switching element (10, 20) and/or
b) downstream of the switching elements (10, 20) as seen from the voltage source.

12. Method according to any one of Claims 8 to 11, **characterized in that**, after a shutdown due to
a) detection of an unequal current, a user intervention takes place before a restart, in particular after a fault analysis and/or troubleshooting by a user, or
b) a control specification by specifying an output limit or a power limit, a restart and/or normal operation is carried out on the basis of internal control specifications.

13. Method according to any one of Claims 8 to 12, **characterized in that** a PSE component (3) according to either one of Claims 6 and 7 is used and operated.

14. Method according to any one of Claims 8 to 13, **characterized in that** the method is used for a supply and data network, in which the data is transmitted and the current is carried together via a two-wire cable, in particular a Single Pair Ethernet, SPE, (4) and/or Twisted Pair Ethernet, TPE.

15. Method according to any one of Claims 8 to 14, **characterized in that** limiting the current includes cutting off the current
- to 0 A or
- to a defined value > 0, in particular a value up to 100 mA.

16. Method according to any one of Claims 8 to 15, **characterized in that** the current intensity (33) of the two switching elements is calculated from the ACTUAL voltage measured values (U_GS) at the two switching elements (10, 20) and that this current intensity (33) is compared with a SETPOINT current intensity specified in the processor unit (6) and additionally with an independently measured ACTUAL current intensity in at least one of two cable paths (30, 31), wherein a shutdown takes place depending on this comparison.

## Revendications

1. Élément de circuit électronique (5) pour un composant PSE (3), ou composant "Power Sourcing Equipment", pour une section de réseau ou un réseau PoDL (1), ou "Power over Data Line", comprenant
- un raccordement de tension (30) et/ou une source de tension,
- une première ligne (31) pour relier un pôle du raccordement de tension (30) à un premier raccordement (8.1) d'un PHY (8),
- une deuxième ligne (32) pour relier le deuxième pôle du raccordement de tension (30) à un deuxième raccordement (8.2) du PHY (8),
- au moins un élément de commutation (10, 20) dans chacune des lignes (31, 32),
**caractérisé en ce que**
les éléments de commutation (10, 20) sont reliés à au moins une unité de commande (15) comprenant un microprocesseur (6) et peuvent être régulés par celle-ci au moyen d'une tension qui est en relation avec l'intensité du courant, et dans lequel il est prévu au moins une unité de mesure de tension (18) au moyen de laquelle une chute de tension peut être détectée en tant que valeur de mesure aux bornes de chaque élément de commutation (10, 20) en tant que valeurs de mesure de tension réelles, et est acheminée au microprocesseur (6),
dans lequel l'unité de commande (15) est conçue pour commander les éléments de commutation (10, 20) en fonction des valeurs de mesure de tension réelles de telle sorte que la chute de tension (U_DS) aux bornes de chaque élément de commutation (10, 20) soit maintenue constante en tant que grandeur de régulation.

2. Élément de circuit (5) selon la revendication 1, **caractérisé en ce qu'**il est prévu un ampèremètre (14.1, 14.2), qui est relié par transmission de données à l'unité de commande (15), pour la mesure d'une intensité de courant sur au moins une ligne (31, 32).

3. Élément de circuit (5) selon l'une quelconque des revendications 1 ou 2, **caractérisé en ce qu'**au moins un élément de commutation (10, 20) est un transistor à effet de champ, FET, et en particulier un transistor à effet de champ normalement fermé, nc.

4. Élément de circuit (5) selon la revendication 3, **caractérisé en ce que** ledit au moins un élément de commutation (10, 20) est un MOSFET ou un IGBT.

5. Élément de circuit (5) selon l'une quelconque des revendications précédentes, **caractérisé en ce que** les éléments de commutation (10, 20) sont structurellement et fonctionnellement identiques.

6. Composant PSE (3) destiné à un réseau PoDL et/ou à une section de réseau PoDL (1), comprenant
- un composant microélectronique (9) doté d'un PHY (8) qui peut être relié par l'intermédiaire d'une ligne à un "Powered Device", PD, (2),
- une circuiterie de sécurité qui comprend une source de tension et/ou peut être reliée à celle-ci, la circuiterie de sécurité étant placée en amont du composant microélectronique (9),
**caractérisé en ce que**
**caractérisé en ce que** la circuiterie de sécurité est conçue en tant qu'élément de circuit (5) selon l'une quelconque des revendications précédentes.

7. Composant PSE (3) selon la revendication 6, **caractérisé en ce que** le PHY (8) comporte deux raccordements (8.1, 8.2), dans lequel un circuit de composants passifs, en particulier un circuit d'au moins une résistance (16) et d'au moins une capacité (17), est directement placé en amont de chacun des raccordements (8.1, 8.2).

8. Procédé de surveillance et de protection d'un réseau et/ou d'une section de réseau PoDL, dans lequel il est prévu, dans deux lignes (31, 32) reliées à une source de tension, au moins un élément de commutation (10, 20) et la chute de tension (U_DS) aux bornes de chaque élément de commutation (10, 20) est mesurée en tant que valeurs de mesure de tension réelles, **caractérisé en ce que** les éléments de commutation (10, 20) sont commandés en fonction des valeurs de mesure de tension réelles au moyen d'une tension de commande qui est en relation avec l'intensité du courant, les éléments de commutation (10, 20) étant commandés en fonction des valeurs de mesure de tension réelles de telle sorte que la chute de tension (U_DS) aux bornes de chaque élément de commutation (10, 20) soit maintenue constante en tant que grandeur de régulation.

9. Procédé selon la revendication 8, **caractérisé en ce que**, dans les deux lignes (31, 32), l'intensité du courant est mesurée de manière techniquement indépendante et les valeurs de mesure et/ou les données qui en sont dérivées sont évaluées conjointement dans une unité à processeur (6).

10. Procédé selon la revendication 9, **caractérisé en ce que** l'intensité du courant (33) dans chaque élément de commutation (10, 20) est déterminée sur la base des tensions de commande de chaque élément de commutation (10, 20) et est comparée aux fins de la surveillance.

11. Procédé selon l'une quelconque des revendications 8 à 10, **caractérisé en ce que** la valeur de mesure de tension réelle est acquise sur les tronçons des lignes (31, 32)
a) entre la source de tension et l'élément de commutation (10, 20) et/ou
b) en vue depuis la source de tension, en aval des éléments de commutation (10, 20).

12. Procédé selon l'une quelconque des revendications 8 à 11, **caractérisé en ce qu'**après une mise hors tension pour les raisons suivantes
a) l'acquisition d'une intensité de courant inégale, une intervention de l'utilisateur se produisant avant une remise sous tension, en particulier après une analyse de défaut et/ou une élimination de défaut par un utilisateur, ou
b) une spécification de la commande, lors de laquelle une limitation de sortie ou une limitation de puissance a été spécifiée, une remise sous tension et/ou un fonctionnement normal ayant lieu en raison de spécifications internes de la commande.

13. Procédé selon l'une quelconque des revendications 8 à 12, **caractérisé en ce qu'**un composant PSE (3) selon l'une quelconque des revendications 6 ou 7 est utilisé et exploité.

14. Procédé selon l'une quelconque des revendications 8 à 13, **caractérisé en ce que** le procédé est utilisé pour un réseau d'alimentation et de données, dans lequel la transmission de données et le transport de courant sont effectués conjointement par l'intermédiaire d'un câble à deux conducteurs, en particulier un Single Pair Ethernet, SPE, (4) et/ou un Twisted Pair Ethernet, TPE.

15. Procédé selon l'une quelconque des revendications 8 à 14, **caractérisé en ce qu'**une limitation du courant consiste **en ce qu'**une mise hors tension
- est effectuée à 0 A ou
- est effectuée à une valeur définie > 0, en particulier à une valeur allant jusqu'à 100 mA.

16. Procédé selon l'une quelconque des revendications 8 à 15, **caractérisé en ce que**, à partir des valeurs de mesure de tension réelles (U_GS) aux bornes des deux éléments de commutation (10, 20), leur intensité de courant (33) est calculée, et **en ce que** cette intensité de courant (33) est comparée à une intensité de courant nominale préétablie dans l'unité à processeur (6) ainsi qu'à une intensité de courant réelle mesurée indépendamment dans au moins l'une des deux voies de ligne (30, 31), une mise hors tension étant effectuée en fonction de cette comparaison.
